# EUROPÄISCHE PATENTSCHRIFT

(11) **EP 2 159 889 B1**
(45) Veröffentlichungstag und Bekanntmachung des Hinweises auf die Patenterteilung: **16.02.2011**
(21) Anmeldenummer: 08105197.1
(22) Anmeldetag: 01.09.2008
(51) Int. Cl.: H01S 5/024

(54) **Laserdioden-Anordnung**
Laser diode assembly
Agencement de diodes laser

(43) Veröffentlichungstag der Anmeldung: 03.03.2010
(73) Patentinhaber: iie Gesellschaft für innovative Industrieelektronik mbH, 83564 Soyen (DE)
(72) Erfinder: Kress, Ekkehard, 83512, Wasserburg am Inn (DE)
(74) Vertreter: Oberhardt, Knut

(56) Entgegenhaltungen:
- EP-A- 0 973 237
- EP-A- 1 450 454
- DE-A1-102005 040 453
- JP-A- 2001 111 176
- JP-A- 2002 344 057
- JP-A- 2004 186 212
- JP-A- 2004 193 228
- US-A- 5 978 396
- US-B1- 6 647 035

## Beschreibung

Die Erfindung betrifft eine Laserdioden-Anordnung nach dem Oberbegriff von Anspruch 1.

Um große Laserleistungen mit preisgünstigen Bauteilen zu erreichen werden mit Hilfe der Wafer-Technik so genannte Laser-Barren hergestellt. Solche Barren werden durch streifenförmige Chips gebildet, die mehrere Einzelemitter nebeneinander enthalten. Die Einzelemitter sind elektrisch parallel geschaltet. Der streifenförmige Chip wird üblicherweise auf eine Wärmesenke montiert.

Ein Laser-Barren enthält ca. 50 Einzelemitter, die jeweils einen Laserstrahl emittieren, der in der einen Richtung (fast axis) ca. 40° und in der anderen Richtung (slow axis) ca. 12° Abstrahlwinkel aufweist. Über Kollimationslinsen werden die Einzelstrahlen zusammengefasst und parallelisiert.

Um noch höhere Laserleistungen zu erreichen werden solche Laser-Barren zu so genannten Stacks gestapelt. Je nach Anwendung sind horizontale wie auch vertikale Stacks bekannt geworden. In diesen Stacks werden die einzelnen Laser-Barren üblicherweise elektrisch in Reihe geschaltet. Mit solchen Stacks lassen sich optische Leistungen von ca. 1 kW erzeugen. Aufgrund der hohen Packungs- und Leistungsdichte werden die einzelnen Barren wiederum auf Wärmesenken montiert. Um eine hohe Standzeit der teuren Laser-Barren zu erreichen, müssen die Wärmesenken durch ein Kühlmittel gekühlt werden, so dass eine Überhitzung der Laser-Barren vermieden werden kann.

Bei bekannten Laserdioden-Anordnungen wird unterhalb der Wärmesenke ein Kühlmittelkanal vorgesehen, der in Richtung der Längsachse der Laser-Barren verläuft. Eine gute Kühlung in dem Bereich, in dem das Kühlmittel in den Kühlmittelkanal eintritt ist deshalb gewährleistet. Beim Durchlauf durch den Kühlkanal heizt sich das Kühlmittel jedoch immer weiter auf, so dass das Kühlmittel in dem Bereich, in dem es aus Kühlmittelkanal wieder austritt nur noch eine geringe Wärmemenge von der Wärmesenke abziehen kann. Es kann daher in diesem Bereich zu einer lokalen Überhitzung der Laser-Barren kommen.

Die EP-A-0 973 237 zeigt eine Halbleiter-Laser-Anordnung mit einer Montageplatte, in die ein Zuführkanal und ein Abführkanal für Kühlflüssigkeit eingearbeitet sind. Für jedes Laserdioden-Array ist eine eigene Wärmesenke vorgesehen und auf der Montageplatte befestigt. Der Zuführ- und der Abführkanal sind über Kühlkanäle miteinander verbunden, die durch jede einzelne Wärmesenke verlaufen.

In der JP 2004 193228 A ist eine Laserdioden-Anordnung gezeigt, die auf einer Wärmesenke montiert ist. Ein Zuführkanal, ein Abführkanal für ein Kühlmittel, sowie Kühlkanäle, die den Zuführ- und den Abführkanal verbinden und nahe an den Laserdioden verlaufen, sind direkt in der Wärmesenke vorgesehen.

Die Laserdioden-Anordnung nach der EP-A-1 450 454 ist ähnlich aufgebaut wie die Anordnung nach der EP-A-0 973 237. Auch hier ist eine Platte vorgesehen, in die ein Zuführkanal und ein Abführkanal für Kühlflüssigkeit eingearbeitet sind. Ebenso ist für jedes Laserdioden-Array eine eigene Wärmesenke vorgesehen und auf der Platte befestigt. Der Zuführ- und der Abführkanal sind in gleicher Weise über Kühlkanäle miteinander verbunden, die durch jede einzelne Wärmesenke verlaufen.

Der Erfindung liegt die Aufgabe zugrunde, eine Laserdioden-Anordnung nach dem Oberbegriff von Anspruch 1 so auszubilden, dass eine gleichmäßige und ausreichende Kühlung über die gesamte Wärmesenke erfolgen kann.

Gelöst wird die Aufgabe gemäß der Erfindung durch eine Laserdioden-Anordnung mit den Merkmalen von Anspruch 1. Bei der erfindungsgemäßen Laserdioden-Anordnung weist der Kühlkörper zwei Kühlmittelkanäle auf, die parallel zu der Längsachse der Wärmesenke verlaufen und als Zuführkanal und als Abführkanal für ein Kühlmittel ausgebildet sind. Weiterhin ist eine Vielzahl von nebeneinander liegenden Kühlkanälen vorgesehen, die von dem Zuführkanal abzweigen, an der Wärmesenke entlang führen und in den Abführkanal münden.

Der Kühlmittelstrom wird folglich bereits in dem Zuführkanal auf eine Vielzahl von Kühlkanälen aufgeteilt. Diese Kühlkanäle verlaufen entlang der Querachse der Wärmesenke. Die Strecke, auf der Wärmeenergie von der Wärmesenke auf das Kühlmittel übertragen werden kann ist dadurch relativ kurz. Daher ist auch der Temperaturunterschied des Kühlmittels von einem Rand der Wärmesenke bis zum anderen Rand gering. Das Kühlmittel kann auf diese Weise überall nahezu die gleiche Wärmemenge von der Wärmesenke aufnehmen. Eine sehr gleichmäßige Kühlung ist dadurch gewährleistet und lokale Überhitzungen der Laser-Barren können sicher verhindert werden. Die Lebensdauer der Laser-Barren steigt dadurch erheblich.

Unter der Wärmesenke, ist parallel zu deren Längsachse, ein Querstromkanal ausgebildet, über den die Kühlkanäle miteinander verbunden sind. Durch diesen Querstromkanal, in den alle Kühlkanäle münden, können Druckunterschiede zwischen den einzelnen Kühlkanälen ausgeglichen werden. Es entsteht auf diese Weise ein sehr gleichmäßiger Kühlmittelstrom unterhalb der Wärmesenke.

Direkt nebeneinander liegende Kühlkanäle zweigen an unterschiedlichen Stellen des Umfangs des Zuführkanals sowie des Abführkanal ab und münden in unterschiedlichen Winkeln in den Querstromkanal. Die Kühlkanäle können auf diese Weise sehr dicht nebeneinander gelegt werden. Die Kühlkanäle können sogar so dicht gepackt werden, dass sie sich im Bereich unterhalb der Wärmesenke überschneiden und gegenüber dem jeweils direkt benachbarten Kühlkanal keine Trennwand mehr aufweisen. In dem Bereich, in dem die Kühlkanäle in den Zuführkanal oder Abführkanal münden, ist jeder Kühlkanal konkret von seinem jeweils direkt benachbarten Kühlkanälen abgetrennt. Dadurch wird jeder Kühlkanal mit Kühlmittel der gleichen Temperatur beschickt. Eine Mischung des Kühlmittels verschiedener Kühlkanäle kann erst unterhalb der Wärmesenke erfolgen.

In vorteilhafter Weise weist die Wärmesenke an ihrer Unterseite ein Profil auf, welches sich in den Querstromkanal erstreckt. Dieses Profil dient der Oberflächenvergrößerung der Wärmesenke. Auf diese Weise kann von der Wärmesenke mehr Wärmeenergie auf das Kühlmittel übertragen werden. Die Form des Profils spielt hierbei eine untergeordnete Rolle. Sie sollte jedoch so ausgeführt sein, dass der Strom des Kühlmittels nicht zu stark behindert wird. Das Profil verhindert weiterhin den Aufbau einer laminaren Strömung, so dass durch die Erzeugung von Turbolenzen eine bessere Mischung der Strömungsschichten erfolgt.

An dem Kühlkörper ist wenigstens eine Klammer befestigt, in der die Laserdioden auf der Wärmesenke befestigt sind und/oder die Wärmesenke auf dem Kühlkörper befestigt ist. Es wird hier in allgemeiner Form von Laserdioden gesprochen. Selbstverständlich ist die Erfindung auf alle Laserdioden-Anordnungen anwendbar, unabhängig davon, in welcher Form die Laserdioden angeordnet sind. In den meisten Fällen werden bereits eine Vielzahl von Laserdioden zusammengefasst sein. Diese Laserbarren werden dann auf der Wärmesenke befestigt. Mit Hilfe der Klammer kann auf einfache Weise ein ausgezeichneter Wärmeübergang zwischen Kühlkörper und Wärmesenke bzw. zwischen Wärmesenke und Laserdioden erzeugt werden. Es lassen sich teure und aufwändige Arbeitsschritte, wie beispielsweise Löten oder Diffusionsschweißen vermeiden. Selbstverständlich ist es auch möglich, die Wärmesenke mit dem Kühlkörper in herkömmlicher Weise, beispielsweise durch Löten zu verbinden und die Klammer nur für die Verbindung zwischen den Laserdioden und der Wärmesenke zu verwenden. Ebenso können die Laserdioden zuerst mit der Wärmesenke über einen Lötvorgang verbunden werden, worauf dann die Wärmesenke mit der Klammer an dem Kühlkörper befestigt wird. Bevorzugt werden jedoch Wärmesenke und Laserdioden über die Klammer auf dem Kühlkörper gehalten.

Bevorzugt ist die Klammer mit dem Kühlkörper verschraubt. Die Klemmkraft, mit der die Klammer auf die Laserdioden drückt, ist auf diese Weise sehr fein dosierbar. Eine Zerstörung der Laserdioden durch zu hohen Klemmdruck lässt sich so sicher vermeiden. Sind die Laserdioden als Laser-Barren verbaut, ist es sinnvoll, für jeden Laser-Barren eine Schraube vorzusehen. Der Klemmdruck kann so sehr gleichmäßig auf die Laser-Barren verteilt werden.

Vor den Laserdioden ist vorteilhaft eine, mit der Laserdioden-Anordnung verbundene, Kollimationslinse angeordnet. Dieser Aufbau gewährleistet, dass eine komplett vormontierte Einheit entsteht, die einen parallelen Laserstrahl ausgibt. Eine entsprechende Justage ist so auf einfache Weise bereits bei der Vormontage der Laserdioden-Anordnung möglich, so dass bei der Montage der Laserdioden-Anordnung in ein Gerät, die Parallelität des ausgehenden Laserstrahls nicht mehr kontrolliert werden muss.

Bei einem Ausführungsbeispiel soll mit der Laserdiodenanordnung ein linienförmiger Lichtstrahl erzeugt werden. Die Kollimationslinse ist zu diesem Zweck als Stablinse ausgebildet und so dimensioniert, dass sie Strahlung von allen Laserdioden erfasst. Es entsteht auf diese Weise ein sehr gleichmäßiger, linienförmiger Laserstrahl. Im Gegensatz zu bekannten Kollimationslinsen ist diese Stablinse einteilig ausgeführt. Sie erstreckt sich über alle montierten Laserdioden bzw. Laserbarren. Die Anforderungen an die Genauigkeit bei der Ausrichtung der Laserbarren ist dadurch zwar höher als bei der Verwendung einer Kollimationslinse für jeden Laserbarren, der gesamte Justageaufwand lässt sich durch diese Maßnahme jedoch reduzieren.

Bevorzugt ist für die Kollimationslinse eine untere Justier-Rinne vorgesehen. Diese Justier-Rinne kann in dem Kühlkörper eingearbeitet sein. Durch die untere Justier-Rinne ist die Position der Stablinse in ihrem unteren Bereich bereits festgelegt. Eine Nachjustierung muss dann lediglich noch im oberen Bereich der Stablinse erfolgen.

Besonders vorteilhaft weist die Kollimationslinse einen runden Querschnitt auf. Hierdurch ist die Justage durch die untere Justier-Rinne bereits ausreichend. Durch diese untere Justier-Rinne wird eine im Querschnitt runde Kollimationslinse bereits vollkommen festgelegt.

Bevorzugt wird auch die Kollimationslinse durch die Klammer gehalten. Insbesondere bei einer runden Kollimationslinse hat die Klammer nur die Aufgabe, die Kollimationslinse in die untere Justier-Rinne zu drücken und dort festzuhalten.

Der Teil der Klammer, der die Kollimationslinse hält, ist federnd mit dem Teil verbunden, mit dem die Laserdioden gehalten werden. Auf diese Weise können die Laserdioden montiert werden, ohne dass der Druck auf die Kollimationslinse dabei zu groß wird. Eine Beschädigung oder Zerstörung der Kollimationslinse kann so verhindert werden. Die Klammer kann einteilig ausgeführt sein, wobei die Verbindung zwischen den beiden Halteteilen so dünn sein sollte, dass sie federnde Eigenschaften aufweist. Die Klammer kann aber auch zweiteilig ausgeführt sein. In diesem Fall werden beide Teile beispielsweise über einen Streifen Federstahl miteinander verbunden.

Bei einer Ausführungsform der Erfindung weist die Klammer eine obere Justier-Rinne für die Halterung der Kollimationslinse auf. Insbesondere bei einer Kollimationslinse, die keinen runden Querschnitt besitzen, ist mit dieser Maßnahme auch der obere Bereich der Kollimationslinse exakt festgelegt.

Bei einem Ausführungsbeispiel der Erfindung wird die Kollimationslinse durch eine eigene Linsenklammer gehalten wird. Dies hat den Vorteil, dass die Kollimationslinse vollkommen unabhängig von den laserdioden montiert werden kann.

Die Linsenklammer ist vorteilhaft an der Klammer oder an dem Kühlkörper befestigt. Bei einer Befestigung an der Klammer sind kann es -je nach Leistung und Größe der Laserdioden-Anordnung - zu sehr engen Platzverhältnissen kommen, die die Montage unnötig erschweren. In so einem Fall ist es oft sinnvoller den Kühlkörper etwas zu vergrößern und die Linsenklammer, genauso wie die Klammer zur Befestigung der Laserdioden, an dem Kühlkörper zu befestigen.

Weitere Einzelheiten und Vorteile der Erfindung ergeben sich aus den Unteransprüchen im Zusammenhang mit der Beschreibung von Ausführungsbeispielen, die anhand der Zeichnung eingehend erläutert werden.

Es zeigt:
- Fig. 1: eine Seitenansicht einer erfindungsgemäßen Laserdioden-Anordnung mit auf- geschnittenem Kühlkörper,
- Fig. 2: die Unteransicht und Rückansicht der Wärmesenke der Laserdioden-Anord- nung und
- Fig. 3: ein weiteres Ausführungsbeispiel der Erfindung.

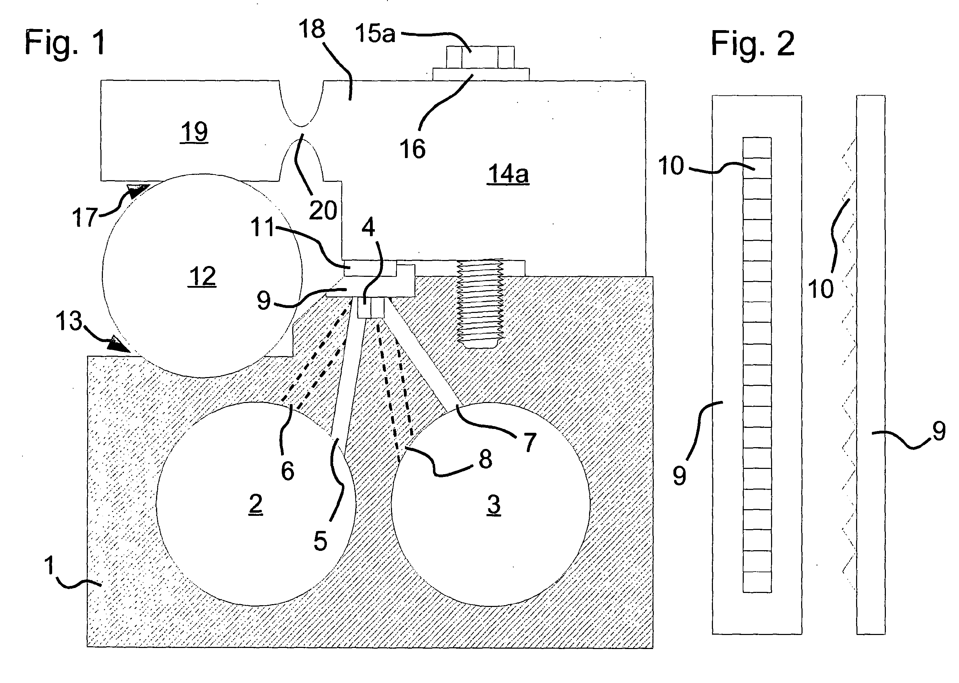

In Fig. 1 ist der Kühlkörper 1 geschnitten dargestellt, so dass die Kühlmittelführung sichtbar ist. Diese weist einen Zuführkanal 2, einen Abführkanal 3, einen Querstromkanal 4 und eine Vielzahl von Kühlkanälen 5, 6, 7, 8 auf. Über einen hier nicht gezeigten Anschluss wird das Kühlmittel in den Zuführkanal 2 eingespeist. Aus dem danebenliegenden Abführkanal 3 wird das Kühlmittel wieder abgezogen. Der Zuführkanal 2 und der Abführkanal 3 stehen über Kühlkanäle 5, 6, 7, 8 miteinander in Verbindung.

Die Wärmesenke 9 ist so auf dem Kühlkörper 1 montiert, dass sie den Querstromkanal 4 nach oben abschließt. Der Querstromkanal 4 ist über erste 5 und zweite zuführende Kühlkanäle 6 mit dem Zuführkanal 2 verbunden. Über erste 7 und zweite abführende Kühlkanäle 8 wird die Verbindung zwischen dem Querstromkanal 4 und dem Abführkanal 3 hergestellt. Die ersten 5 münden in einem anderen Winkel als die zweiten zuführenden Kühlkanäle 6 in den Querstromkanal 4, sowie auch die ersten 8 in einem anderen Winkel als die zweiten abführenden Kühlkanäle 7 in den Querstromkanal 4 münden. Da jeweils die ersten 5 und die zweiten zuführenden Kühlkanäle 6 jeweils an anderen Stellen des Umfangs des des Zuführkanals 2, bzw. die ersten 7 und die zweiten abführenden Kühlkanäle 8 jeweils an anderen Stellen des Umfangs des des Abführkanals 3 ansetzen, können die Kühlkanäle 5, 6 bzw.7, 8 so dicht gepackt sein, dass sie sich im Bereich des Querstromkanals 4 sogar überschneiden. In diesem Bereich der Überschneidung existieren keine Trennwände zwischen den Kühlkanälen 5, 6 bzw. 7, 8

Die Wärmesenke 9 ist, wie in Fig. 2 dargestellt, an ihrer Unterseite mit einem Profil 10 versehen. In dem gezeigten Ausführungsbeispiel ist das Profil 10 beispielhaft sägezahnförmig ausgestaltet. Es könnte jedoch auch ein anderes Profil verwendet werden, beispielsweise ein Rechteckprofil . Durch das Profil 10 soll die Oberfläche der Wärmesenke 9, die mit dem Kühlmittel in Berührung kommt, vergrößert werden, so dass auch eine größere Wärmemenge von der Wärmesenke 9 auf das Kühlmittel übertragen werden kann.

Es soll durch das Profil 10 aber auch verhindert werden, dass sich eine laminare Strömung zwischen den zuführenden Kühlkanälen 5, 6 und den abführenden Kühlkanälen 7, 8 ausbildet. Bei einer laminaren Strömung würde der Schichtaufbau erhalten bleiben und das Kühlmittel in der obersten Strömungsschicht würde sich nicht mit den darunter befindlichen, kühleren Strömungsschichten vermischen. Die oberste Strömungsschicht würde so eine höhere Temperatur erreichen und weniger Wärmeenergie aufnehmen können.

Auf der Wärmesenke 9 sind die Laser-Barren 11 montiert. Beispielsweise können drei Laser-Barren nebeneinander auf der Wärmesenke 9 angeordnet sein. Die Wärmesenke 9 ist an ihrer Vorderkante nach unten abgeschrägt, so dass die Abstrahlung des emittierten Laserlichts nicht behindert wird.

In Strahlrichtung, vor den Laser-Barren 11, befindet sich eine runde Stablinse 12. Die Stablinse 12 wirkt als Kollimationslinse und parallelisiert das von den Laserdioden emittierte Laserlicht in der slow scan Richtung. In der fast scan Richtung überstrahlen sich benachbarte Laserdioden gleichmäßig, so dass ein harmonisierter, linienförmiger Laserstrahl entsteht. Die Stablinse 12 liegt in einer unteren Justier-Rinne 13 und ist damit bereits vollständig festgelegt.

Die Laserdioden-Anordnung wird über die Klammer 14a zusammengehalten. Die Unterseite der Klammer 14a ist zu diesem Zweck in drei Stufen unterteilt. Die rechte Stufe liegt auf dem Kühlkörper 1 auf und bildet die Basis der Klammer 14a. Die mittlere Stufe drückt auf die Laserbarren 11. Die Klammer 14a hält auf diese Weise nicht nur die Laserbarren 11 in vollflächigem Kontakt mit der Wärmesenke 9, sondern drückt die Wärmesenke 9 auch mit großer Kraft auf den Kühlkörper 1, so dass der Querstromkanal 4 abgedichtet wird. Zur besseren Abdichtung des Querstromkanals kann aber auch noch Dichtmaterial verwendet werden. Es muss auf diese Weise weder die Wärmesenke 9 mit dem Kühlkörper 1, noch müssen die Laserbarren 11 mit der Wärmesenke 1 in anderer Weise verbunden werden.

Der Druck der Klammer 14a auf die Laserbarren 11 muss vollkommen gleichmäßig ausgeübt werden, so dass eine gute Wärmeübertragung von den Laserbarren 11 auf die Wärmesenke 9 erfolgen kann. Hier kann bei kleinsten Ungleichmäßigkeiten bereits eine lokale Überhitzung erfolgen und zu einer Zerstörung der Laserbarren 11 führen.

Um den Druck der Klammer 14a gleichmäßig einstellen zu können sind die Schrauben 15a vorgesehen. Sie ragen durch eine Bohrung in der Klammer 14a und sind in einer Gewindebohrung in dem Kühlkörper 1 verankert. Um beim Anziehen der Schrauben 15a zu vermeiden, dass die Klammer 14a durch die Drehung des aufliegenden Schraubenkopfes mitbewegt wird, sind die Isolierscheiben 16 vorgesehen. Diese können aus einem hitzebeständigen, hochfesten Kunststoff, aber auch aus Keramikmaterial gefertigt sein.

Die linke Stufe der Klammer 14a dient der Halterung der Stablinse 12. Sie ist als Halteteil 19 für die Stablinse 12 ausgeführt. Die Verbindung zwischen dem Halteteil 18 für die Laserbarren 11 und dem Halteteil 19 für die Stablinse 12 ist als Federsteg 20 ausgeführt. Der Federsteg 20 soll es ermöglichen, die Laserbarren 11 zu klemmen, ohne dabei zu hohen Druck auf die Stablinse 12 auszuüben. Die Klemmung von Stablinse 12 und Laserbarren 11 wird damit in begrenztem Umfang unabhängig von einander. Bei dem gezeigten Ausführungsbeispiel ist die Klammer 14a einteilig ausgeführt, wobei die als Federsteg 20 ausgeführteVerbindung zwischen den beiden Halteteilen 18 und 19 so dünn sein sollte, dass sie federnde Eigenschaften aufweist.

Die Klammer 14a könnte auch zweiteilig ausgebildet sein. In diesem Fall müssten die beiden Halteteile 18 und 19 beispielsweise über einen Federbügel oder einen Streifen Federstahl miteinander verbunden werden.

In dem gezeigten Ausführungsbeispiel ist in dem Halteteil 19 für die Stablinse 12 die obere Justier-Rinne 17 eingearbeitet. Bei einer Stablinse mit rundem Querschnitt ist diese obere Justier-Rinne 17 jedoch nicht unbedingt notwendig, da die Stablinse bereits durch die untere Justier-Rinne 13 exakt festgelegt ist. Es würde hier ausreichen, wenn das Halteteil 19 mit einer geraden Unterseite versehen wäre.

Bei einer als normale Sammellinse ausgebildeten Stablinse mit elliptischem Querschnitt muss jedoch auch der obere Bereich exakt fixiert werden, da die Position dieser Stablinse nur durch die untere Justier-Rinne noch nicht ausreichen festgelegt ist. Hierfür ist die obere Justier-Rinne 17 in der Klammer 14a von besonderer Bedeutung.

Die exakte Positionierung einer solchen Stablinse mit Hilfe der oberen Justier-Rinne 17 kann aber nur erfolgen, wenn auch die Klammer 14a genau positioniert ist. Zu diesem Zweck kann die rechte Stufe an der Unterseite der Klammer 14a etwas höher ausgebildet sein. In den Kühlkörper 1 wird eine Nut mit entsprechender Tiefe und mit trichterförmig angeschrägten Seitenwänden eingearbeitet. Die Breite des Bodens der Nut entspricht genau der Breite der rechten Stufe der Klammer 14a.

Beim Anziehen der Schrauben 15a wird nun die rechte Stufe der Klammer mit ihrer unteren Begrenzungsfläche bis auf den Boden der Nut gedrückt und durch die angeschrägten Seitenwände in dieser zentriert. Die Position der Klammer 14a und damit auch die Position der Stablinse ist auf diese Weise absolut exakt fixiert.

Um auch die Laserbarren 11 exakt positionieren zu können, ist an der Rückseite der Wärmesenke 9 ein Flansch angeformt. An diesen stufenartigen Flansch können die Laserbarren 11 vor dem Anziehen der Schrauben 15a eng angelegt werden.

Es ist aber auch möglich eine Wärmesenke ohne stufenartigen Flansch zu verwenden. In diesem Fall wird für die Positionierung der Laserbarren 11 eine Montage-Lehre benutzt. Die Montage-Lehre kann eine vordere und eine hintere Anlageschiene aufweisen und an den Seiten des Kühlkörpers 1 verschraubt werden. Nachdem die Schrauben 15a angezogen wurden, kann die Montage-Lehre wieder entfernt werden.

Sollte aufgrund größerer Toleranzen bei der Herstellung der Laserbarren eine Nachjustierung der Stablinse 12 erforderlich werden, kann der Kühlkörper 1 entsprechend abgeändert werden. Zu diesem Zweck wird die untere Justier-Rinne 13 in einem separaten Bauteil vorgesehen. Dieses Bauteil wird über hier nicht näher beschriebene Justiermittel mit dem Kühlkörper 1 verbunden.

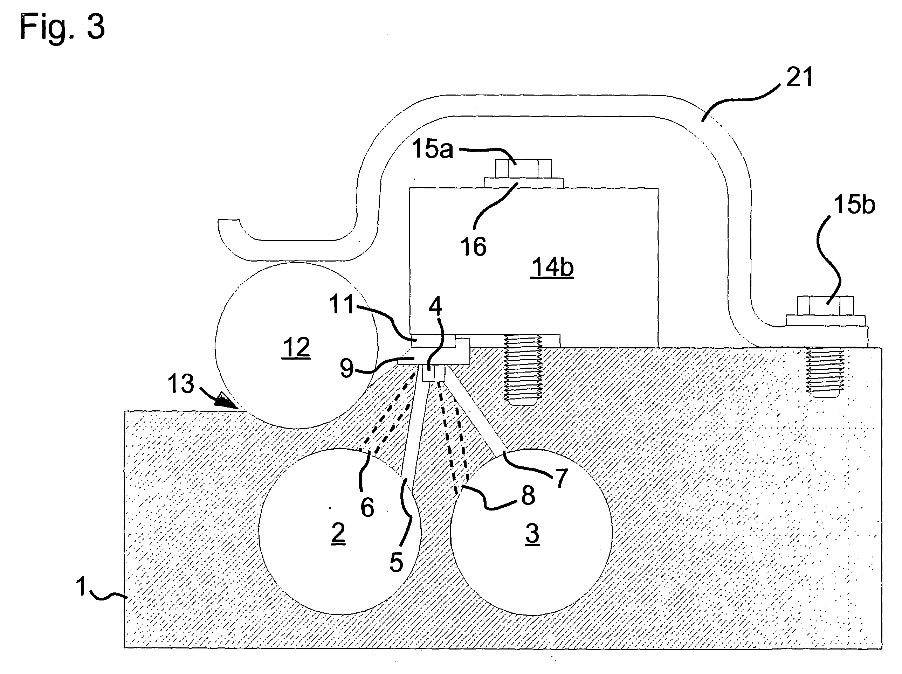

In Fig. 3 ist ein anderes Ausführungsbeispiel der Erfindung dargestellt. Die Klammer 14b ist hier ausschließlich für die Halterung der Laserbarren 11 bestimmt. Für die Halterung der Stablinse 11 ist eine eigene Linsenklammer 21 vorgesehen. Diese Linsenklammer 21 ist mit einer Schraube 15b ebenfalls an dem Kühlkörper 1 befestigt. Die Linsenklammer ist vorteilhaft aus Federstahl gefertigt und weist eine Vorspannung auf, die bei angezogener Schraube 15b die Stablinse 12 in die untere Justier-Rinne 13 drückt.

Bei diesem Ausführungsbeispiel werden zuerst die Laserbarren 11 mit der Klammer 14b montiert. Danach kann vollkommen unabhängig die Stablinse 12 mit der Linsenklammer 21 befestigt werden.

### Bezugszeichenliste:

- 1: Kühlkörper
- 2: Zuführkanal
- 3: Abführkanal
- 4: Querstromkanal
- 5: erster zuführender Kühlkanal
- 6: zweiter zuführender Kühlkanal
- 7: erster abführender Kühlkanal
- 8: zweiter abführender Kühlkanal
- 9: Wärmesenke
- 10: Profil
- 11: Laser-Barren
- 12: Stablinse
- 13: untere Justier-Rinne
- 14: Klammer
- 15: Schraube
- 16: Isolierscheibe
- 17: obere Justier-Rinne
- 18: Halteteil für Laserbarren
- 19: Halteteil für Kollimationslinse
- 20: Federsteg
- 21: Linsenklammer

## Patentansprüche

1. Laserdioden-Anordnung mit einer Vielzahl nebeneinander angeordneter Laserdioden (11), mit einer Wärmesenke (9), auf der die Laserdioden (11) montiert sind und mit einem Kühlkörper (1), der in innigem Kontakt mit der Wärmesenke (9) steht, wobei der Kühlkörper (1) zwei Kühlmittelkanäle (2; 3) aufweist, die parallel zu der Längsachse der Wärmesenke (9) verlaufen und als Zuführkanal (2) und als Abführkanal (3) für ein Kühlmittel ausgebildet sind, wobei eine Vielzahl von nebeneinander liegenden Kühlkanälen (5, 7; 6, 8) vorgesehen ist, die von dem Zuführkanal (2) abzweigen, als Querstromkanal (45) an der Wärmesenke (9) entlang führen und in den Abführkanal (3) münden, **dadurch gekennzeichnet, dass** direkt nebeneinander liegende Kühlkanäle (5, 7; 6, 8) an unterschiedlichen Stellen des Umfangs des Zuführkanals (2) sowie des Abführkanal (3) abzweigen und in unterschiedlichen Winkeln in den Querstromkanal (4) münden.

2. Laserdioden-Anordnung nach Anspruch 1, **dadurch gekennzeichnet, dass** unter der Wärmesenke (9) parallel zu deren Längsachse ein Querstromkanal (4) ausgebildet ist, über den die Kühlkanäle (5, 7; 6, 8) mit einander verbunden sind.

3. Laserdioden-Anordnung nach Anspruch 2, **dadurch gekennzeichnet, dass** die Wärmesenke (9) an ihrer Unterseite ein Profil (10) aufweist, welches sich in den Querstromkanal (4) erstreckt.

4. Laserdioden-Anordnung nach Anspruch 3, **dadurch gekennzeichnet, dass** an dem Kühlkörper (1) wenigstens eine Klammer (14) befestigt ist, mit der die Laserdioden (11) auf der Wärmesenke (9) und/oder die Wärmesenke (9) auf dem Kühlkörper (1) befestigt sind bzw. ist.

5. Laserdioden-Anordnung nach Anspruch 4, **dadurch gekennzeichnet, dass** die Klammer (14) mit dem Kühlkörper (1) verschraubt ist.

6. Laserdioden-Anordnung nach Anspruch 5, **dadurch gekennzeichnet, dass** vor den Laserdioden (11) eine mit der Laserdioden-Anordnung verbundene Kollimationslinse (12) angeordnet ist.

7. Laserdioden-Anordnung nach Anspruch 6, **dadurch gekennzeichnet, dass** die Kollimationslinse als Stablinse (12) ausgebildet ist, die so dimensioniert ist, dass sie Licht von allen Laserdioden (11) erfasst.

8. Laserdioden-Anordnung nach Anspruch 7, **dadurch gekennzeichnet, dass** für die Kollimationslinse (12) eine untere Justier-Rinne (13) vorgesehen ist.

9. Laserdioden-Anordnung nach Anspruch 8, **dadurch gekennzeichnet, dass** die Kollimationslinse (12) einen runden Querschnitt aufweist.

10. Laserdioden-Anordnung nach Anspruch 7, **dadurch gekennzeichnet, dass** die Kollimationslinse (12) durch die Klammer (14) gehalten wird.

11. Laserdioden-Anordnung nach Anspruch 10, **dadurch gekennzeichnet, dass** der Teil (19) der Klammer (14a), der die Kollimationslinse (12) hält, federnd mit dem Teil (18) verbunden ist, mit dem die Laserdioden (11) gehalten werden.

12. Laserdioden-Anordnung nach Anspruch 10, **dadurch gekennzeichnet, dass** die Klammer (14a) eine obere Justier-Rinne (17) für die Halterung der Kollimationslinse (12) aufweist.

13. Laserdioden-Anordnung nach Anspruch 7, **dadurch gekennzeichnet, dass** die Kollimationslinse (12) durch eine Linsenklammer (21) gehalten wird.

14. Laserdioden-Anordnung nach Anspruch 13, **dadurch gekennzeichnet, dass** die Linsenklammer (21) an der Klammer (14b) oder an dem Kühlkörper (1) befestigt ist.

## Claims

1. A laser diode assembly, comprising a plurality of laser diodes (11) arranged side by side, comprising a heat sink (9), on which the laser diodes (11) are mounted and a cooling block (1) in snug contact with the heat sink (9), the cooling block (1) including two cooling medium channels (2; 3) extending parallel to the longitudinal axis of the heat sink (9) and configured as a supply channel (2) and a drain channel (3) for a cooling medium, wherein a plurality of cooling channels (5, 7; 6, 8) is provided side by side, which branch off from the supply channel (2), and run along the heat sink (9) as a crossflow channel (4), and open out into the drain channel (3), **characterized in that** cooling channels (5, 7; 6, 8) disposed directly next to each other branch off from the circumference of the supply channel (2) and the drain channel (3) at different places and open out into the crossflow channel (4) at different angles.

2. The laser diode assembly according to claim 1, **characterized in that** a crossflow channel (4) is formed beneath the heat sink (9) parallel to its longitudinal axis, linking the cooling channels (5, 7; 6, 8) with each other.

3. The laser diode assembly according to claim 2, **characterized in that** the heat sink (9) has a profile (10) on its bottom surface extending into the crossflow channel (4).

4. The laser diode assembly according to claim 3, **characterized in that** at least one clamp (14) is fixed on the cooling block (1) for fixing the laser diodes (11) on the heat sink (9) and/or the heat sink (9) on the cooling block (1).

5. The laser diode assembly according to claim 4, **characterized in that** the clamp (14) is screw-fastened on the cooling block (1).

6. The laser diode assembly according to claim 5, **characterized in that** a collimation lens (12) associated with the laser diode assembly is arranged in front of the laser diodes (11).

7. The laser diode assembly according to claim 6, **characterized in that** the collimation lens is formed as a rod lens (12), which is dimensioned such that it captures light from all laser diodes (11).

8. The laser diode assembly according to claim 7, **characterized in that** a bottom adjustment groove (13) is provided for the collimation lens (12).

9. The laser diode assembly according to claim 8, **characterized in that** the collimation lens (12) has a round cross-section.

10. The laser diode assembly according to claim 7, **characterized in that** the collimation lens (12) is held by the clamp (14).

11. The laser diode assembly according to claim 10, **characterized in that** the part (19) of the clamp (14a) holding the collimation lens (12) is resiliently connected to the part (18) used for holding the laser diodes (11).

12. The laser diode assembly according to claim 10, **characterized in that** the clamp (14a) has a top adjustment groove (17) for holding the collimation lens (12).

13. The laser diode assembly according to claim 7, **characterized in that** the collimation lens (12) is held by a lens clamp (21).

14. The laser diode assembly according to claim 13, **characterized in that** the lens clamp (21) is attached to the clamp (14b) or to the cooling block (1).

## Revendications

1. Agencement de diodes laser avec une pluralité de diodes laser disposées les unes à côté des autres (11), avec un dissipateur thermique (9) sur lequel sont montées les diodes laser (11) et avec un corps de refroidissement (1), qui se trouve en contact étroit avec le dissipateur thermique (9), dans lequel le corps de refroidissement (1) présente deux canaux à agent réfrigérant (2 ; 3), qui passent parallèlement à l'axe longitudinal du dissipateur thermique (9) et sont conçus comme un canal d'alimentation (2) et comme un canal d'évacuation (3) pour un agent réfrigérant, dans lequel est prévue une pluralité de canaux de refroidissement (5, 7 ; 6, 8) se trouvant les uns à côté des autres, qui se séparent du canal d'alimentation (2), comme canal de courant transversal (4) mènent le long du dissipateur thermique (9) et débouchent dans le canal d'évacuation (3), **caractérisé en ce que** des canaux de refroidissement (5, 7 ; 6, 8) se trouvant directement les uns à côté des autres se séparent à différents endroits de la périphérie du canal d'alimentation (2) ainsi que du canal d'évacuation (3) et débouchent à angles divers dans le canal de courant transversal (4).

2. Agencement de diodes laser selon la revendication 1, **caractérisé en ce que** sous le dissipateur thermique (9), parallèlement à son axe longitudinal, est conçu un canal de courant transversal (4), au moyen duquel les canaux de refroidissement (5, 7 ; 6, 8) sont reliés ensemble.

3. Agencement de diodes laser selon la revendication 2, **caractérisé en ce que** le dissipateur thermique (9) présente sur son côté inférieur un profil (10), qui s'étend dans le canal de courant transversal (4).

4. Agencement de diodes laser selon la revendication 3, **caractérisé en ce que** sur le corps de refroidissement (1) au moins une bride de fixation (14) est fixée, avec laquelle sont ou bien est fixée(s) les diodes laser (11) sur le dissipateur thermique (9) et/ou le dissipateur thermique (9) sur le corps de refroidissement (1).

5. Agencement de diodes laser selon la revendication 4, **caractérisé en ce que** la bride de fixation (14) est vissée avec le corps de refroidissement (1).

6. Agencement de diodes laser selon la revendication 5, **caractérisé en ce que** devant les diodes laser (11) est disposée une lentille de collimation (12) reliée à l'agencement de diodes laser.

7. Agencement de diodes laser selon la revendication 6, **caractérisé en ce que** la lentille de collimation est conçue comme une lentille en barre (12) qui est dimensionnée de manière telle qu'elle prend la lumière de toutes les diodes laser (11).

8. Agencement de diodes laser selon la revendication 7, **caractérisé en ce que** pour la lentille de collimation (12) une rainure d'ajustement inférieure (13) est prévue.

9. Agencement de diodes laser selon la revendication 8, **caractérisé en ce que** la lentille de collimation (12) présente une section transversale ronde.

10. Agencement de diodes laser selon la revendication 7, **caractérisé en ce que** la lentille de collimation (12) est maintenue par la bride de fixation (14).

11. Agencement de diodes laser selon la revendication 10, **caractérisé en ce que** la partie (19) de la bride de fixation (14a), qui maintient la lentille de collimation (12), est reliée de façon élastique avec la partie (18) avec laquelle les diodes laser (11) sont maintenues.

12. Agencement de diodes laser selon la revendication 10, **caractérisé en ce que** la bride de fixation (14a) présente une rainure d'ajustement supérieure (17) pour le maintien de la lentille de collimation (12).

13. Agencement de diodes laser selon la revendication 7, **caractérisé en ce que** la lentille de collimation (12) est maintenue par une bride de fixation de lentilles (21).

14. Agencement de diodes laser selon la revendication 13, **caractérisé en ce que** la bride de fixation de lentilles (21) est fixée à la bride de fixation (14b) ou au corps de refroidissement (1).
